# EUROPEAN PATENT APPLICATION

(11) **EP 3 745 246 A1**
(43) Date of publication of application: **02.12.2020**
(21) Application number: 18724117.9
(22) Date of filing: 23.03.2018
(51) Int. Cl.: G06F 3/14

(54) **DISPLAY DEVICE, ELECTRONIC APPARATUS AND SCREEN DISPLAY CONTROL METHOD**

(30) Priority: 26.01.2018 CN 201810078618
(71) Applicant: Mobvoi Information Technology Co., Ltd., Beijing 100094 (CN)
(72) Inventor: CAO, Huanjie, Haidian District Beijing (CN)
(74) Representative: Cabinet Beau de Loménie
(86) International application number: PCT/CN2018/080297
(87) International publication number: WO 2019/144490

(57) **Abstract**

A display device, an electronic device, and a display control method for a screen are provided. The display device includes a display module, a controller, and a temperature sensor, wherein the display module includes at least two layers of display panels; the temperature sensor is connected to the controller, and the controller is respectively connected to the at least two layers of display panels in the display module; the temperature sensor is configured to detect an ambient environment temperature and send the environment temperature to the controller; and the controller is configured to control, according to the environment temperature, the at least two layers of display panels to perform time-sharing display.

## Description

The present application is proposed based on and claims the priority of the Chinese patent application No. 201810078618.8 filed on January 26, 2018, the entirety of which is herein incorporated by reference.

### Technical Field

The present disclosure relates to the technical field of display, for example, relates to a display device, an electronic device, and a display control method for a screen.

### Background Art

As users increase the frequency of using electronic devices with display screens, especially smart wearable devices, the users' requirements on standby time of electronic devices also gradually increased, so as not to affect the use of electronic devices in case of inconvenient charging. Currently, display devices of some electronic devices adopt at least two display panel switching modes with different power consumption to achieve low-power display panels to display relevant information in the electronic device without high visual display requirements, so as to reduce unnecessary power consumption of the electronic device and indirectly increase the standby time of the electronic device.

However, when a multi-layer display panel in a display device is switched, the display device is affected by the surrounding environment temperature, resulting in poor user experience. Specifically, when the surrounding environment temperature is high, the response speed of the multi-layer display panel becomes faster, so that a display panel will be closed during screen switching, and another display panel is not lighten up and waken up, resulting in blank display; when the surrounding environment temperature is low, due to the slow response time of the multi-layer display panel, display content of the display panel does not fade during the screen switching, and another display panel has been lighten up and waken up, so that display overlapping occurs.

### Summary of the Invention

Below is a summary of the subject matter detailed in this text. This summary is not intended to limit the scope of protection of the claims.

The present disclosure provides a display device, an electronic device, and a display control method for a screen, so as to avoid blank display or display overlapping when display panels of an electronic device perform switching display.

An embodiment provides a display device. The display device includes a display module, a controller, and a temperature sensor, wherein
the display module includes at least two layers of display panels; the temperature sensor is connected to the controller, and the controller is respectively connected to the at least two layers of display panels in the display module;
the temperature sensor is configured to detect an ambient environment temperature and send the environment temperature to the controller; and the controller is configured to control, according to the environment temperature, the at least two layers of display panels to perform time-sharing display.

An embodiment further provides an electronic device, and the electronic device includes the display device provided in any embodiment.

An embodiment further provides a display control method for a screen, the method including:
obtaining an environment temperature when it is detected that a screen switching condition is satisfied;
determining a time difference between closing time of a first display panel and opening time of a second display panel according to the environment temperature;
determining the closing time of the first display panel and the opening time of the second display panel according to the time difference; and
closing the first display panel when reaching the closing time, and opening the second display panel when reaching the opening time.

In this embodiment, a temperature sensor is disposed on a display device including a display module formed by at least two layers of display panels and a controller, and the controller controls, according to the environment temperature, the at least two layers of display panels to perform time-sharing display. The above technical solution is used to resolve issues of blank display or display overlapping when the display device switches display panels under different environment temperatures, thereby enhancing user visual experience.

Other aspects can be understood after reading and understanding the drawings and detailed descriptions.

### Brief Description of the Drawings

FIG. 1 is a schematic structural diagram of a display device in Embodiment 1;
FIG. 2 is a schematic structural diagram of another display device in Embodiment 1;
FIG. 3 is a schematic structural diagram of a display module and a temperature sensor in Embodiment 1;
FIG. 4 is a schematic structural diagram of another display module and another temperature sensor in Embodiment 1;
FIG. 5 is a schematic structural diagram of another display module and another temperature sensor in Embodiment 1;
FIG. 6 is a flowchart of a display control method for a screen in Embodiment 3; and
FIG. 7 is a schematic structural diagram of a screen display control device in Embodiment 4.

### Detailed Description of the Invention

In relevant technologies, a suitable time window is selected to consider display panel's response speeds at high and low temperatures. However, the above method cannot effectively resolve blank display or display overlapping issues when the display device switches display panels under different environment temperatures. Regarding this problem, some embodiments provide a display device.

### Embodiment 1

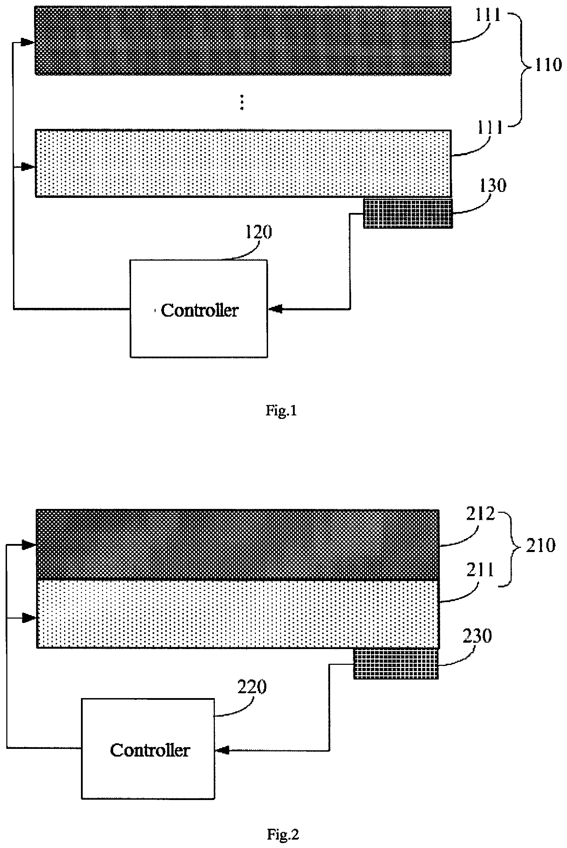

FIG. 1 is a schematic structural diagram of a display device in Embodiment 1. The display device includes a display module 110, a controller 120, and a temperature sensor 130, where the display module 110 includes at least two layers of display panels 111, that is, multiple display panels 111; the temperature sensor 130 is connected to the controller 120, and the controller 120 is respectively connected to the multiple display panels 111 in the display module 110; the temperature sensor 130 is configured to detect an ambient environment temperature and send the environment temperature to the controller 120; and the controller 120 is configured to control, according to the environment temperature, the display panels 111 to perform time-sharing display.

The quantity of the controller 120 in FIG. 1 may be one or two. When there are at least two controller 120s, different controllers 120 are respectively connected to different display panels 111 in the display module110, and the at least two controllers 120 are configured to control, under respective working states, the connected display panel 111 to display.

Different display panels 111 may be combined to compose the display module 110 by a bonding procedure. In addition, the display panel bonded on an upper layer of the display module has relatively high transparency, so that when any display panel on a lower layer is used for information display, it will not be affected by the upper layer display panel, so as to ensure a display effect of the lower layer display panel.

The controller 120 may be, but not limited to, connected to multiple display panels 111 by a bus. An installation position of the temperature sensor 130 is not defined, and may be attached to the display module 110.

During an actual use process, according to the ambient environment temperature detected by the temperature sensor 130, the controller 120 controls multiple display panels 111 with different power consumption to perform time-sharing display; during a process of switching multiple display panels 111, the opening time and the closing time of a switched display panel and a target switch display panel are adjusted to resolve blank display or display overlapping when the display device switches display panels under different environment temperatures, thereby enhancing user visual experience. Power consumption of the multiple display panels 111 may be same or different. Exemplarily, when the multiple display panels 111 have different power consumption, when user display requirements are satisfied, the composed display module 110 switches from a display panel with high power consumption to a display panel with low power consumption, thereby reducing unnecessary display power consumption of the display device, extending standby time of the display device, and achieving effects of power saving and reducing the power consumption.

In an embodiment, FIG. 2 is a specific schematic structural diagram of a provided in Embodiment 1, including a display module 210, a controller 220, and a temperature sensor 230. The display module 210 includes a first display panel 211 and a second display panel 212. A light-emitting surface of the first display panel 211 is disposed on one side of the second display panel 212 departing from the light-emitting surface, and power consumption of the second display panel 212 is lower than that of the first display panel 211; the temperature sensor 230 is connected to the controller 220, and controller 220 is respectively connected to the first display panel 211 and the second display panel 212 in the display module 210; the temperature sensor 230 is configured to detect an ambient environment temperature and send the environment temperature to the controller 220; the controller 220 is configured to control, according to the environment temperature, the first display panel 211 and the second display panel 212 to perform time-sharing display. The second display panel 212 has relatively high transparency, so that when the first display panel 211 displays, a display effect of the first display panel 211 can be ensured.

During an actual use process, after detecting the ambient environment temperature, the temperature sensor 230 sends the environment temperature to the controller 220; the controller 220 controls, according to the environment temperature, a first display panel 211 with high power consumption and a second display panel 212 with low power consumption to perform time-sharing display. Moreover, during a switch display process of the first display panel 211 and the second display panel 212, the opening time and the closing time of the switched display panel and the target switch display panel are adjusted to resolve blank display or display overlapping issue when the display device switches display panels under different environment temperatures, which enhances user visual experience, thereby reducing unnecessary display power consumption of the display device, extending standby time of the display device, and achieving effects of power saving and reducing the power consumption.

Based on the display device shown in FIG. 2, the controller 220 may be extended to two. When there are two controllers 220, one controller 220 is connected to the first display panel 211 by a bus or other methods, so as to control opening or closing of the first display panel 211; another controller 220 is connected to the second display panel 212 by a bus or other methods, so as to control opening or closing of the second display panel 212. The temperature sensor 230 is respectively connected to two controllers 220. When detecting the ambient environment temperature, the temperature sensor 230 respectively sends the environment temperature to multiple controllers 220. One controller 220 controls opening or closing of the first display panel 211 based on a first time node. A second time node is determined based on the first time node by adding a specific time difference, and another controller 220 controls closing or opening of the second display panel 211 in the second time node. The time difference may be a positive value or a negative value, and determining of the second time node may be implemented by any controller 220.

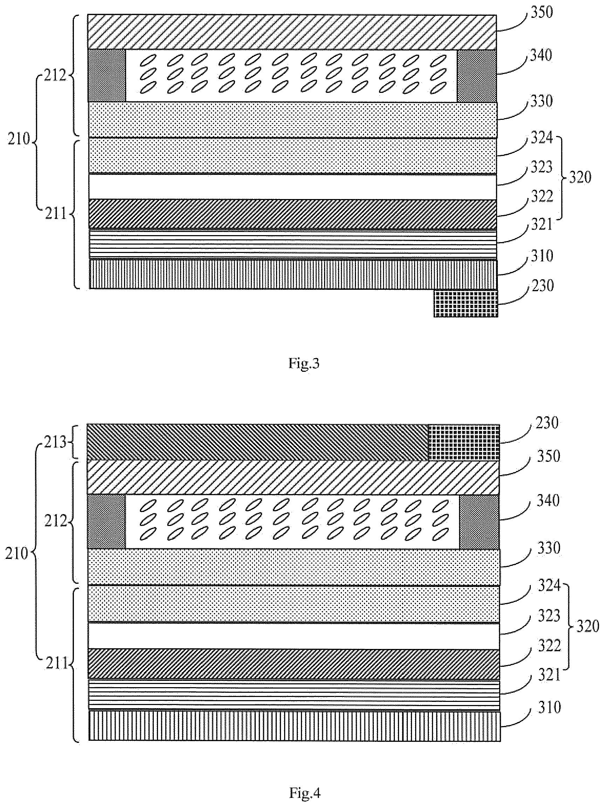

Based on the display device provided by the technical solutions of the above multiple embodiments, FIG. 3 is a schematic structural diagram of a display module and a temperature sensor included in multiple display devices. The display module 210 includes a first display panel 211 and a second display panel 212.

The first display panel 211 is an organic light-emitting display panel, and the second display panel 212 is a liquid crystal display panel.

The organic light emitting display panel 211 is not interfered with the liquid crystal display panel 212 during time-sharing display. The liquid crystal display panel 212 should be a transparent panel and does not include a backlight source, because if the liquid crystal display panel 212 includes the backlight source, the panel will shield the organic light emitting display panel 211 on a lower layer. Meanwhile, to enable the liquid crystal display panel 212 to normally display, the organic light emitting display panel 211 needs to provide a backlight source. Considering that the organic light emitting display panel 211 generally includes a metal layer as a metal cathode, a person skilled in the art inventively proposes to use the metal layer in the organic light-emitting display panel 211 as a backlight source used by the liquid crystal display panel 212. Time-sharing display of dual display panels may be implemented through the above clever setting.

In an embodiment, the organic light emitting display panel 211 specifically includes: a first substrate 310;
an organic light emitting structure 320 in an array distribution located on one side of the first substrate 310;
the organic light emitting structure 320 includes a hole-transporting layer 321, an organic light-emitting layer 322, an electronic transmission layer 322, and a metal layer 324 that are sequentially cascaded.

The metal layer 324 included in the liquid crystal display panel 212 and the metal layer 324 included in the organic light emitting display panel 211 are disposed close to each other, so that the metal layer 324 can be directly used as a backlight source of the liquid crystal display panel 212. Environment light irradiates the metal layer 324, and reflected by the metal layer 324. The environment light reflected by the metal layer 324 provides a light source for the liquid crystal display panel 212.

The organic light emitting structure 320 includes a red organic light-emitting structure, a green organic light-emitting structure, and a blue organic light-emitting structure. The red organic light-emitting structure radiates red light, the green organic light-emitting structure radiates green light, and the blue organic light-emitting structure radiates blue light.

Specifically, because the red organic light-emitting structure, the green organic light-emitting structure, and the blue organic light-emitting structure have different luminance and different types of lights after being lighten up (only one or two organic light-emitting structures are lighten up, or all the organic light-emitting structures are lighten up), so that the organic light emitting structure 320 presents different colors. The radiation of the organic light emitting structure 320 is an injected type radiation. Simply, the electrons injected from the cathode and the holes injected from the anode interact with each other to form excited excitons. When the excitons return from the excited state to the ground state, the energy difference is released as photons.

In an embodiment, the organic light-emitting display panel 110 may include an active-matrix organic light-emitting diode (AMOLED) panel.

A basis of the AMOLED is an organic light-emitting object. Thousands of light sources that emit only one of the three colors red, green, or blue are placed on the substrate of the screen in a specific form. Thousands of light sources that emit only one of the three colors, that is red, green, or blue, are placed on the substrate of the screen in a specific form. These light emitters emit red, green, or blue when a voltage is applied, and voltage conversion also needs to rely on thin film transistors (TNTs). After adjusting the ratio of the three primary colors, multiple colors can be emitted.

OLED, that is an organic light-emitting diode, which is also called an organic electroluminescent device, whose basic structure includes an anode, a cathode and a light-emitting layer corresponding to each pixel area. When a voltage is applied to the anode and the cathode, holes move to the light-emitting layer through the hole transport layer, electrons move to the light-emitting layer through the electron transport layer, and both recombine in the light-emitting layer. Excitons in the light-emitting layer material are migrated from an excited state to a ground state for light emission. The organic light emitting structures of different colors correspond to different light emitting layer materials, and the light emitting layer materials corresponding to the respective organic light emitting structures of different colors respectively emit light of different colors under the action of the anode voltage and the cathode voltage of the organic light emitting structure.

There are a number of mature AMOLED products on the market. In order to filter out clutter and increase the display contrast of AMOLEDs, a layer of circular polarizers is generally attached to the top of the metal layer in the AMOLED. Therefore, in order to reduce the implementation steps of this embodiment and save the development cost, in this embodiment, the circular polarizer can be removed on the basis of existing AMOLED products and directly used as the organic light emitting display panel 211 of this embodiment.

Exemplarily, the requirement may be directly presented when the manufacturer's AMOLED screen is purchased, so that the manufacturer can reduce the process of attaching a circular polarizer in the production process, and an AMOLED screen that does not include a circular polarizer can be obtained directly, that is, the organic light emitting display panel 211. In this embodiment, the organic light emitting display panel 211 composed of AMOLED can implement colored display, and the liquid crystal display panel 212 can implement black-white display. For example, if a user only needs to display time and dates, the liquid crystal display panel 212 can be used for display; if a user needs to display Wechat, the organic light emitting display panel 211 can be used for display.

The inventors have found through experiments that the use of the liquid crystal display panel 212 for displaying content that does not require color display can minimize power consumption and save power, in particular, an electronic device composed of a display device with a relatively small battery capacity and a relatively short battery life, such as a smart watch or a smart wristband, can be used. The introduction of the above display module 210 can also play a greater role.

Generally, the cost of the liquid crystal display panel 212 is cheap. In the solution of this embodiment, the liquid crystal display panel 212 is introduced, thereby greatly improving power consumption of the configured device without obviously increasing production cost, and bringing obvious user experiment and product competitiveness. In an embodiment, the liquid crystal display panel 212 specifically includes a second substrate 330, a liquid crystal layer 340, and a third substrate 350 that are sequentially cascaded.

The second substrate 330 and the organic light emitting display panel 211 include the metal layer 324 which is disposed close to each other, and the second substrate 330 and the third substrate 350 are made of transparent materials.

By means of the above setting, the liquid crystal display panel 212 is a transparent panel. Therefore, when the organic light emitting display panel 211 of the low layer works, the liquid crystal display panel 212 has a small effect on it. Although the display contrast and color saturation of the organic light emitting display panel 211 will be sacrificed to some extent, the above-mentioned sacrifice can be compensated in a software manner.

The liquid crystal display panel 212 may include a film compensation super twisted nematic (FSTN) display panel.

The outside of the liquid crystal display panel 212 generally includes a compensation film. This compensation film is usually made of a polymer and also has birefringence. When the o- and e-lights pass through the compensation film, an additional phase difference is generated, so that the phases of the o-light and the e-light are delayed or compensated, thereby changing the interference color of the polarized light. The compensation film in the FSTN can be located below the polarizer or on top of the polarizer. One or two can be used. Some of the two compensation film systems also function as collimators. The above compensation film also has the function of a scattering film so that the viewing angle of the liquid crystal display can be increased without affecting the response speed of the liquid crystal display.

The relationship between contrast and viewing angle FSTN is thin film compensated super twisted nematic (STN), can achieve black and white display. FSTN has strict requirements on the retardation and direction of polymer films. Compared with the yellow-green mode STN, the yellow-green mode FSTN has much better viewing angle characteristics and contrast, and the contour line with a contrast greater than 5 covers a much wider area. Regions with a contrast greater than 10 are also larger than the yellow-green STN.

Combined with the schematic structural diagram of the display module and the temperature sensor shown in FIG. 3, the temperature sensor 230 may be disposed on any position of the display device, preferably to be disposed close to the liquid crystal display panel 212. Certainly, the temperature sensor 230 may be installed by insert-bonding in the third substrate 350, but this may increase the cost of manufacturing the display panel 210 due to a complicated process flow. FIG. 3 merely exemplarily shows a case where the temperature sensor 230 is provided near the liquid crystal display panel 212 without changing the physical structure of the display module 210.

Based on the display module and the temperature sensor shown in FIG. 3, FIG. 4 is another schematic structural diagram of the display module and the temperature sensor provided in Embodiment 1. The display module 210 also includes transparent glass 213, and the transparent glass 213 is disposed on one side of the second display panel 212 where a light-emitting surface is located.

The transparent glass 213 is disposed in the display module 210 so as to protect the first display panel 211 and the second display panel 212 in the display device.

Exemplarily, FIG. 4 shows a technical solution of installing the temperature sensor 230 into the transparent glass 213 by insert-bonding. The temperature sensor 230 may be also installed into a first substrate 310, an organic light emitting structure 320, a second substrate 330, a liquid crystal layer 340, or a third substrate 350 by insert-bonding. Certainly, to simplify the process flow and manufacturing cost of producing the display module 210, it can be disposed near the first substrate 310. Exemplarily, the temperature sensor 230 can also be installed on the light emitting surface side of the display module 210 without affecting the appearance of the display device and not impeding the use of the user, so as to enhance the reliability of the ambient environment temperature detected by the temperature sensor 230.

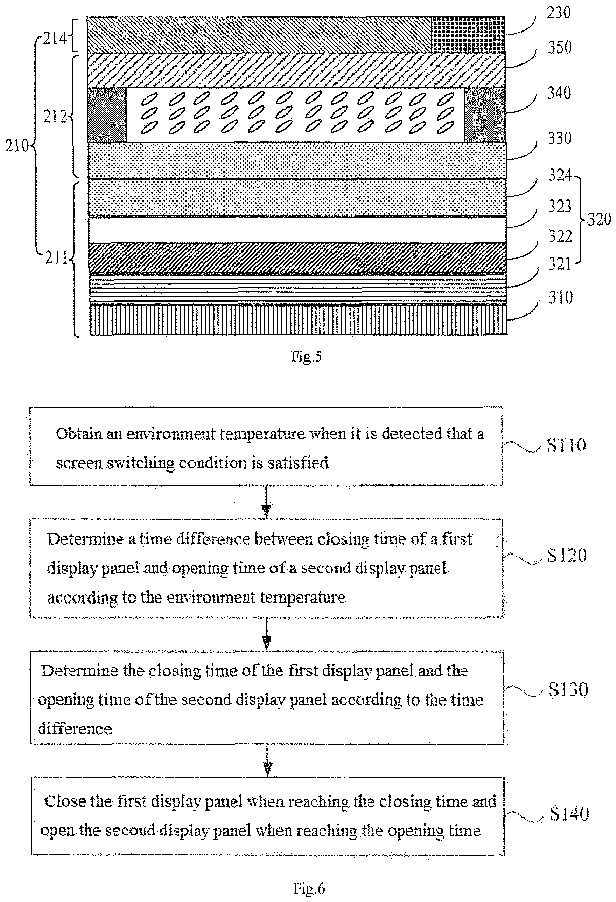

Based on the display module and the temperature sensor shown in FIG. 3, in an embodiment, FIG. 5 shows a schematic structural diagram of the display module and the temperature sensor provided in Embodiment 1. The display module 210 also includes a touch screen 214, where the touch screen 214 is disposed on one side of the light-emitting surface of the second display panel 212, and the touch screen 214 is connected to the controller (not shown in the figure).

The touch screen 214 is configured to obtain touch position information and sends the touch position information to the controller.

The touch screen 214 is disposed in the display module 210 to implement interaction between the user and the display device, so that the user can operate the display device more conveniently.

Exemplarily, FIG. 5 shows a technical solution of installing a temperature sensor 230 into the touch screen 214 by insert-bonding. The temperature sensor 230 may also be installed into the first substrate 310, the organic light emitting structure 320, the second substrate 330, the liquid crystal layer 340, or the third substrate 350 in insert-bonding. Certainly, in order to simply the process flow and manufacturing cost of producing the display module 210, it can be disposed near the first substrate 310. Exemplarily, the temperature sensor 230 can also be installed on the light emitting surface side of the display module 210 without affecting the appearance of the display device and not impeding the use of the user, so as to enhance the reliability of the ambient environment temperature detected by the temperature sensor 230.

Based on the technical solutions of the above embodiments, the display device includes a smart hand ring or a smart watch.

Based on the technical solutions of the above embodiments, the quantity of the controller included in the display device may be two. The specific connection method is disposed in the above technical solutions of this embodiment, and is not described herein again.

### Embodiment 2

Embodiment 2 further provides an electronic device, and the electronic device includes a display device provided in technical solutions of any above embodiment.

### Embodiment 3

FIG.6 is a flowchart of a display control method for a screen provided by Embodiment 3. This embodiment may be applicable to situations that time-sharing display is performed by the display device provided in any embodiment through switching multiple display panels under a certain ambient environment. The method may be performed by a screen control device, and the device is implemented by at least one of software or hardware, and is configured in the display device. The method includes the following content: S110 to S140. In S110, an environment temperature is obtained when it is detected that a screen switching condition is satisfied.

In this step, when the controller detects that the screen switching condition is satisfied, the controller obtains an ambient environment temperature detected by a temperature sensor.

The screen switching condition may include any one of the following: it is detected that a user input operation instruction selects to use a display panel; it is detected that the display device performs mode switch (for example, switching from a general mode to a charging mode), it is detected that the relationship between the illumination intensity of the display device and a preset intensity threshold changes and it is detected that the length of the display device standby time exceeds a preset time threshold, and it is detected that the relationship between the complexity of the user trigger event and a preset complexity threshold value changes (for example, the complexity of the trigger event exceeds the maximum complex threshold or the trigger event complexity is below the minimum complex threshold).

The user's input operation may be a somatosensory gesture input by the user. For example, the user may raise the wrist, shake the arm, or perform different definitions for different times of the somatosensory gestures, for example, shaking arm once corresponds to that the user wants to select a certain display panel as a display screen, and shaking the arm twice in succession corresponds to that the user wants to select another display panel as a display screen. Alternatively, the user inputs an instruction via a mechanical button on the electronic device, for example, the input of the instruction may be performed via the crown of a smart watch.

A case where it is detected that the display device performs mode switching is that when the smart wristband is in a motion mode or a charging mode, the user can switch to a display panel with low power consumption if the user does not need to view the application software.

A case where the display panel is switched when it is detected that the length of the standby time of the display device exceeds a preset time threshold is that: when the light intensity is greater than the preset intensity threshold, it indicates that the current ambient light has a higher light intensity, which needs higher screen brightness. Therefore, a display panel with low power consumption is required to display the power to reduce power consumption of the display device. When the light intensity is not greater than the preset intensity threshold, the light intensity of the current ambient light is small, and the screen brightness is required to be low. Therefore, a display panel with high power consumption may be used for display. The preset light intensity threshold may be adjusted according to an attribute of the display panel or set according to actual requirements.

The change in the detected relationship between the complexity of the user trigger event and a preset complexity threshold may be: the complexity of all the trigger events that can be generated is evaluated in advance, and the complexity is determined according to the complexity of the screen that needs to be displayed. Triggering events can be viewing time, listening to music, broadcasting, or opening applications, etc. Events such as "viewing time" and "viewing weather" can be defined as lower complexity events; "opening application" is defined as a higher complexity event, etc. When the complexity of the event exceeds the preset complexity threshold, it indicates that the event has a high demand for display and needs to be displayed with a high-power display panel; when an auxiliary level of the event does not exceed the preset complex threshold, it indicates that the event has a lower demand for display, so low-power display panels can be used for display.

In S120, a time difference between the closing time of the first display panel and the opening time of the second display panel is determined according to the environment temperature.

The first display panel and the second display panel in this embodiment are different from the first display panel and the second display panel in above embodiments. The first display panel in this embodiment is a display panel that is currently in normal display, that is, a switched display panel. The second display panel in this embodiment is a display panel to be displayed, that is, a target switch display panel.

The controller may determine the time difference between the first display panel and the second display panel according to the environment temperature. Specifically, the time difference is the closing time of the first display panel and the opening time of the second display panel. The time difference may be a positive value or a negative value. Exemplarily, if the response time of the first display panel is less than that of the second display panel, the time difference is a negative value; and if the response time of the first display panel is greater than that of the second display panel, the time difference is a positive value.

In S130, closing time of the first display panel and opening time of the second display panel are determined according to the time difference.

In this step, if the time difference is a positive value, after obtaining the time difference, the controller sends a closing instruction to the first display panel, so as to control the first display panel to close display, and determines the moment of sending the closing instruction as the closing time. The controller determines the opening time after the closing time by summing the closing time and the time difference. The controller will then send an opening instruction to the second display panel at the opening time to control the second display panel to be displayed.

If the time difference is a negative value, after obtaining the time difference, the controller sends an opening instruction to the second display panel, so as to control the second display panel to start displaying, and determine a moment of sending the opening instruction as the opening time. The controller determines the closing time after the opening time according to subtracting the opening time and the time difference. The controller then sends the closing instruction to the first display panel at the closing time, so as to control the first display panel to close displaying.

In S140, when the closing time is reached, the first display panel is closed, and when the opening time is reached, the second display panel is opened.

In this embodiment, when it is detected that the screen switching condition is satisfied, the environment temperature detected by the temperature sensor is obtained; a time difference between the closing time of the first display panel and the opening time of the second display panel is determined according to the environment temperature; closing time of the first display panel and the opening time of the second display panel is determined according to the time difference; the first display panel is closed when the closing time is reached and the second display panel is open when the opening time is reached, so as to control multiple display panels to perform time-sharing display. The above technical solution is used to solve issues of blank display or display overlapping when the display device switches display panels under different environment temperatures, thereby enhancing user visual experience.

Based on the technical solution of the above embodiment, in an embodiment, the determining a time difference between the closing time of the first display panel and the opening time of the second display panel according to the environment temperature includes:
determining the closing time of the first display panel and the opening time of the second display panel according to the environment temperature and a preset time difference correspondence.

The preset time difference correspondence may be obtained through massive experiments and tests so as to obtain an environment temperature and a time difference corresponding to the environment temperature. A calculation formula between the environment temperature and the time difference can be determined by data fitting, and the calculation formula is used as a preset time difference correspondence. The controller may use the environment temperature detected by the temperature sensor as an input variable of the preset time difference, and finally determine the time difference corresponding to the environment temperature. The time difference is specifically the time difference between the closing time of the first display pane and the opening time of the second display panel.

Based on the technical solutions of the above embodiments, in one embodiment, different switch relationships correspond to different time difference calculation formulas.

The switch relationship is determined by a panel type of the first display panel and the second display panel. The switch relationship is correspondingly as follows: when the first display panel is an organic light-emitting display panel and the second display panel is a liquid crystal display panel, a switch relationship of switching from the organic light-emitting panel to the liquid crystal display panel is determined as a first switching relationship; when the first display panel is a liquid crystal display panel and the second display panel is an organic light-emitting display panel, a switch relationship of switching from the liquid crystal display panel to the organic light-emitting display panel is determined a second switch relationship.

The response time of the organic light-emitting display panel is less than that of the liquid crystal display panel. Meanwhile, multiple display panels, especially, the response time of the liquid crystal display panel from opening to closing and from closing to opening is different. Therefore, a preset time difference correspondence corresponding to the first switch relationship of switching from the organic light-emitting display panel to the liquid crystal display panel is different from a preset time difference correspondence corresponding to the second switch relationship of switching from the liquid crystal display panel to the organic light-emitting display panel. Correspondingly, when the time difference is determined according to the environment temperature in S120, the controller may selects a corresponding preset time difference calculation formula according to the switch relationship.

### Embodiment 4

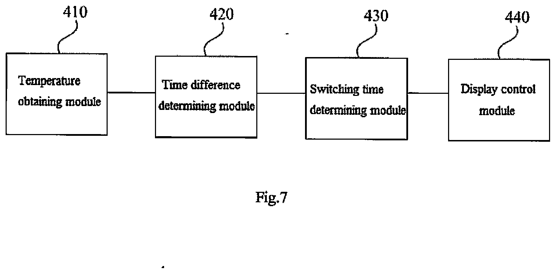

FIG. 7 is a schematic structural diagram of a screen display control device provided by Embodiment 4. This embodiment can be applied to the case where the display device provided by any embodiment is used to perform time-sharing display by switching multiple display panels under a certain surrounding environment. The device includes a temperature obtaining module 410, a time difference determining module 420, a switching time determining module 430, and a display control module 440.

The temperature obtaining module 410 is configured to obtain an environment temperature when it is detected that a screen switching condition is satisfied.

The time difference determining module 420 is configured to determine a time difference between closing time of the first display panel and opening time of the second display panel according to the environment temperature.

The switching time determining module 430 is configured to determine the closing time of the first display panel and the opening time of the second display panel according to the time difference.

The display control module 440 is configured to close the first display panel when reaching the closing time and open the second display panel when reaching the opening time.

In this embodiment, when it is detected that a screen switching condition is satisfied, a temperature obtaining module obtains an environment temperature detected by a temperature sensor; a time difference determining module determines a time difference between closing time of the first display panel and opening time of the second display panel according to the environment temperature; a switching time determining module determines the closing time of the first display panel and the opening time of the second display panel according to the time difference; and a display control module closes the first display panel when reaching the closing time and opens the second display panel when reaching the opening time, so as to control multiple display panels to perform time-sharing display. The above technical solution is used to solve issues of blank display or display overlapping when the display device switches display panels under different environment temperatures, thereby enhancing user visual experience.

Based on the technical solutions of the above embodiment, in an embodiment, the time difference determining module 420 includes:
a time difference determining unit, configured to determine a time difference between closing time of a first display panel and opening time of a second display panel according to an environment temperature and a preset the time difference correspondence.

Based on the technical solutions of the above embodiment, in an embodiment, different switch relationships correspond to different time difference calculation formulas.

The switch relationship is determined according to the panel type of the first display panel and the second display panel.

The above screen display control device may execute the display control method for a screen provided in any embodiment, and has corresponding functional modules and beneficial effects of performing the display control method for the screen.

### Embodiment 5

This embodiment also provides a computer-readable storage medium on which a computer program is stored. When the program is executed by the screen display control device, a display control method for a screen provided by the present embodiment is implemented. The method includes: obtaining an environment temperature detected by a temperature sensor when it is detected that a screen switching condition is satisfied; determining a time difference between closing time of a first display panel and opening time of a second display panel according to the environment temperature; determining the closing time of the first display panel and the opening time of the second display panel according to the time difference; and closing the first display panel when reaching the closing time, and opening the second display panel when reaching the opening time.

By means of the above description of the embodiments, a person skilled in the art can clearly understand that the present application can be implemented by means of software and necessary general hardware, and certainly can also be achieved by hardware, but in many cases, the former is a better implementation manner. Based on such understanding, the technical solutions of the present application can be embodied in the form of a software product that can be stored in a computer-readable storage medium, such as a computer's floppy disk, Read-Only Memory (ROM), Random Access Memory (RAM), flash (FLASH), a hard disk, or an optical disk, etc., including multiple instructions for making a computer device (may be a personal computer, a terminal, or a network device) to perform methods described in the embodiments.

### Industrial applicability

The display device provided in the present disclosure resolves issues of blank display or display overlapping when the display device switches display panels under different environment temperatures, thereby enhancing user visual experience.

## Claims

1. A display device, comprising a display module, a controller, and a temperature sensor, wherein the display module comprises at least two layers of display panels; the temperature sensor is connected to the controller, and the controller is respectively connected to the at least two layers of display panels in the display module;
the temperature sensor is configured to detect an ambient environment temperature and send the environment temperature to the controller; and
the controller is configured to control, according to the environment temperature, the at least two layers of display panels to perform time-sharing display.

2. The display device according to claim 1, wherein the display module comprises a first display panel and a second display panel, a light-emitting surface of the first display panel is disposed on one side away from a light-emitting surface of the second display panel, and power consumption of the second display panel is lower than power consumption of the first display panel.

3. The display device according to claim 2, wherein the first display panel comprises an organic light-emitting display panel, and the second display panel comprises a liquid crystal display panel.

4. The display device according to claim 3, wherein the temperature sensor is disposed by attaching the liquid crystal display panel.

5. The display device according to claim 3, wherein the display module further comprises transparent glass, and the transparent glass is disposed on one side where the light-emitting surface of the second display panel is located.

6. The display device according to claim 3, wherein the display module further comprises a touch screen, and the touch screen is disposed on one side where the light-emitting surface of the second display panel is located, and the touch screen is connected to the controller; and
the touch screen is configured to obtain touch position information and send the touch position information to the controller.

7. An electronic device, comprising the display device according to any one of claims 1 to 6.

8. A display control method for a screen, comprising:
obtaining an environment temperature when it is detected that a screen switching condition is satisfied;
determining a time difference between closing time of a first display panel and opening time of a second display panel according to the environment temperature;
determining the closing time of the first display panel and the opening time of the second display panel according to the time difference; and
closing the first display panel when reaching the closing time, and opening the second display panel when reaching the opening time.

9. The method according to claim 8, wherein the determining a time difference between closing time of a first display panel and opening time of a second display panel according to the environment temperature comprises:
determining the time difference between the closing time of the first display panel and the opening time of the second display panel according to the environment temperature and a preset time difference correspondence.

10. The method according to claim 9, wherein different switching relationships between the first display panel and the second display panel correspond to different time difference calculation formulas; and
the switching relationships are determined by panel types of the first display panel and the second display panel.
